# EUROPÄISCHE PATENTANMELDUNG

(11) **EP 0 973 202 A2**
(43) Veröffentlichungstag der Anmeldung: **19.01.2000**
(21) Anmeldenummer: 99109475.6
(22) Anmeldetag: 12.05.1999
(51) Int. Cl.: H01L 27/144

(54) **Transceivermodul**

(30) Priorität: 17.07.1998 DE 19832151
(71) Anmelder: ROBERT BOSCH GMBH, 70442 Stuttgart (DE)
(72) Erfinder: Hauer, Heiner, 70734 Fellbach (DE); Moess, Eberhard, 71540 Murrhardt (DE); Schwaderer, Bernhard Dr., 71554 Weissach (DE); Hirche, Klaus, 71332 Waiblingen (DE)

(57) **Zusammenfassung**

Zweck ist die elektromagnetische Entkopplung eines Senders und eines Empfängers eines Transceivermoduls. Dieser weist einen Chip auf, der in Flip-Chip-Technik auf einem Substrat aufgebaut ist. Auf diesem Flip-Chip(8) ist zwischen einem elektrischen Senderanschluß (20, 21) einerseits und einem elektrischen Empfängeranschluß (22, 23) andererseits eine elektromagnetisch abschirmende Reihe von Flip-Chip-Bumps (12) in einer Linie (13, 14) angeordnet, die mit einer Leiterbahn (15a, 15b) auf dem Substrat elektrisch verbunden sind. Dabei sind die Abstände dieser Flip-Chip-Bumps (12) voneinander und der Abstand zwischen Flip-Chip (8) und Substrat im allgemeinen nicht größer als ein Viertel der kürzesten elektrischen Wellenlänge des Transceivermoduls, die der höchsten Frequenz entspricht, welche vom Senderanschluß (2) auf den Empfängeranschluß (1) übersprechen kann.

Anwendung bei elektrooptischen und elektrischen Transceivermodulen.

## Beschreibung

### Stand der Technik

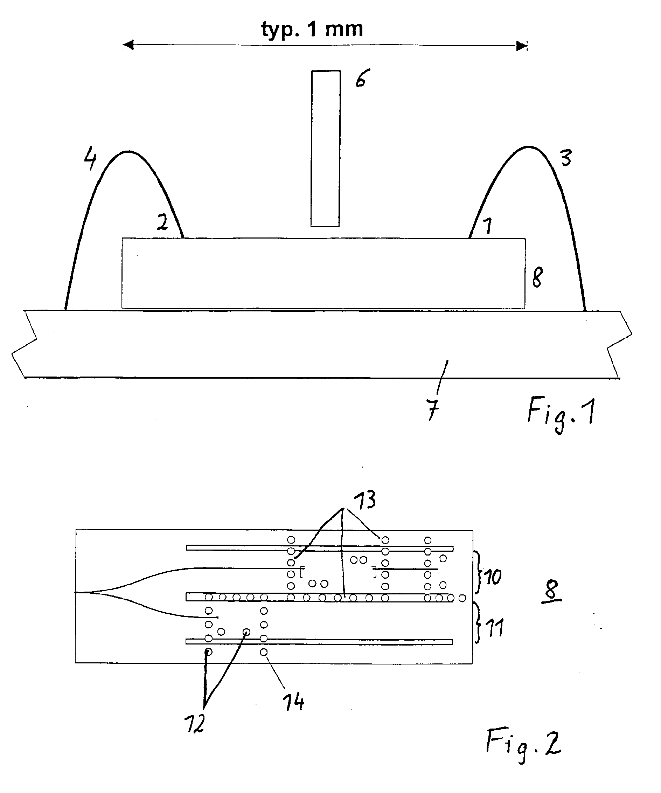

Die Erfindung geht von der Gattung aus, wie im unabhängigen Anspruch 1 angegeben. Transceivermodule sind Module die optische oder elektrische Sende- und Empfangselemente in einem gemeinsamen Gehäuse auf kleinem Raum vereinen, z.B. Photo- und Laserdioden in optoelektronischen Transceivern. Ein großes Problem beim Aufbau kompakter Transceivermodule ist das elektrische Übersprechen aufgrund der kleinen Abstände zwischen den elektrischen Anschlüssen der Komponenten. Dieses Problem verschärft sich aufgrund sehr geringer Abstände beim Einsatz sogenannter Photonic Integrated Circuits (PICs) nochmals, die auf einer Chipfläche von beispielsweise nur 2x1 mm² Sende- und Empfangskomponenten und die erforderlichen elektrischen Anschlüsse integriert enthalten. Bei einer angestrebten Empfangsempfindlichkeit von beispielsweise -30 dBm liegen typische Photodiodenströme unter 10 nA (am Anschluss 1 des Empfangszweigs des Transceiver-Chips, Figur 1), typische Lasermodulationsströme sind größer 10 mA (am Anschluß 2 des Sendezweigs des Transceiver-Chips, der auf einem Substrat 7 angeordnet ist, Figur 1). Somit liegt die zu fordernde elektrische Übersprechdämpfung zwischen Lasermodulationsstrom und Photodiodenstrom über 120 dB! Dies ist eine Forderung, die auch an der Grenze der meßtechnischen Nachweisbarkeit liegt, die beispielsweise mit vektoriellen Netzwerkanalysatoren zu erreichen ist. Die Forderung verschärft sich noch mit zunehmender Bitrate (typisch ≥ 155 Mbit/s).

Ursache für elektrisches Übersprechen in Modulen sind kapazitive oder induktive, elektromagnetische Kopplungen, beispielsweise zwischen eng benachbarten Bonddrähten 3, 4 (Figur 1), sowie leitungsgebundenes Übersprechen, beispielsweise auf Versorgungsleitungen.

Eine Verringerung des Übersprechens kann beispielsweise durch das in der Herstellung aufwendige Einbringen metallischer Abschirmwände oder -elemente 6 (Figur 1) erreicht werden.

Bekannt ist für PICs ein Verfahren (Gutierrrez-Aitken et al.: Low crosstalk (<-40 dB) in 1.55 µm high speed OEIC photoreceiver arrays with novel on-chip shielding, Electronic Letters, 1996, Vol. 32, No. 18, pp. 1706-1708), bei dem die auf dem PIC befindlichen Elemente durch einen metallischen Überzug entkoppelt werden, was aber zusätzliche, aufwendige Herstellungsschritte während des Herstellungsprozesses erfordert. Dabei wird auch nicht das durch die erforderlichen externen Anschlüsse (wie Bonddrähte) gegebene Problem des Übersprechens gelöst.

### Vorteile der Erfindung

Ein seit langem in der Halbleitertechnik bekanntes Verfahren zum Aufbau und zur Kontaktierung von Halbleiterchips ist die Flip-Chip-Technik. Bedingt durch technische Fortschritte und damit einhergehende Kostenreduzierung findet die Flip-Chip-Technik immer weitere Verbreitung auch beim Aufbau von optischen oder Mikrowellen-Komponenten. Die dabei erforderlichen Kontaktelemente, die sogenannten 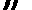 Bumps", können sowohl auf den Kontaktflächen des Substrats als auch auf den Kontakten des darauf zu montierenden Chips aufgebracht werden. Die von der Herstellung der Transceiver-Chips getrennte Aufbringungsmöglichkeit der Bumps erhöht die Flexibilität bei der Herstellung. Ein bekannter Vorteil liegt auch in der Möglichkeit einer präzisen Selbstjustage optischer Komponenten.

Zweck der Erfindung ist die elektromagnetische Entkopplung eines Senders und eines Empfängers eines Transceivermoduls. Dieser weist einen Chip auf, der in Flip-Chip-Technik auf einem Substrat aufgebaut ist. Auf diesem Flip-Chip ist zwischen einem elektrischen Senderanschluß einerseits und einem elektrischen Empfängeranschluß andererseits mindestens eine elektromagnetisch abschirmende Reihe von beispielsweise 4, 5, ... , 10 oder mehr Flip-Chip-Bumps in einer Linie angeordnet, die mit einer Leiterbahn auf dem Substrat elektrisch verbunden sind. Dabei sind die Abstände dieser Flip-Chip-Bumps voneinander und der Abstand zwischen Flip-Chip und Substrat typischerweise nicht größer als ein Viertel der kürzesten Sendewellenlänge des Transceivermoduls, die der höchsten Frequenz entspricht, welche vom Senderanschluß (2) auf den Empfängeranschluß (1) übersprechen kann.

Mit der vorliegenden Erfindung werden die Möglichkeiten der Flip-Chip-Montage genutzt, um die elektrische Übersprechdämpfung zwischen Sende- und Empfangszweig eines aufgebauten Transceiver-ICs zu erhöhen. Der Einsatz der Flip-Chip-Technik ermöglicht die Verringerung des Übersprechens durch geeignete Kombination von Chip- und Boardlayout. Damit ergibt sich für den Anmeldungsgegenstand mit den Merkmalen des Anspruches 1 ein kompakter Aufbau und eine geringe EMV-Empfindlichkeit. Eine Rückseitenmetallisierung des Transceiver-Chips ist als zusätzliche Schirmfläche nutzbar.

Die Erfindung ist nicht nur bei Transceivern in der optischen Nachrichtentechnik (siehe die Figuren) sondern auch in der Mikrowellentechnik (Transceiver für Mobiltelefone etc.) einsetzbar.

Vorteilhafte Weiterbildungen sind in den abhängigen Ansprüchen angegeben, deren Merkmale auch, soweit sinnvoll, miteinander kombiniert werden können.

### Zeichnung

Ein Ausführungsbeispiel der Erfindung ist in den Zeichnungen dargestellt und im folgenden näher erläutert. Dabei sind bei mehreren Figuren jeweils dieselben Bezugszeichen für im wesentlichen gleiche Teile verwendet.

Schematisch ist gezeigt in
- Figur 1:: ein Schnitt durch eine Anordnung mit einem Transceiver-Chip nach dem Stand der Technik,
- Figur 2:: das Layout eines Transceiver-Photonic-Integrated-Circuits nach der Erfindung,
- Figur 3:: das zugehörige Substratlayout (ergänzt durch einen Lasertreiber-IC und einen Vorverstärker-IC),
- Figur 4:: ein Ausschnitt eines Schnittes A - A durch die Anordnung nach Figur 3,
- Figur 5:: ein Beispiel für mehrere einander benachbarte Reihen von Flip-Chip-Bumps.

Figur 1 zeigt im Schnitt auf einem Substrat 7 einen Transceiver-Chip 8, der links seinen Sendezweig und rechts seinen Empfangszweig aufweist. Der elektrische Anschluß 1 (Empfängerausgang) des Empfangszweiges ist über einen Bonddraht 3 mit einem Leiter auf dem Substrat 7 verbunden, während der elektrische Anschluß 2 (Sendereingang)des Sendezweiges über einen Bonddraht 4 mit einem anderen Leiter auf dem Substrat 7 verbunden ist. Zur Abschirmung zwischen Empfangs- und Sendezweig ist eine Abschirmung 6 vorgesehen, die mit Bezugspotential verbunden ist (beispielsweise Masse- oder Erdpotential).

### Beschreibung des Ausführungsbeispiels

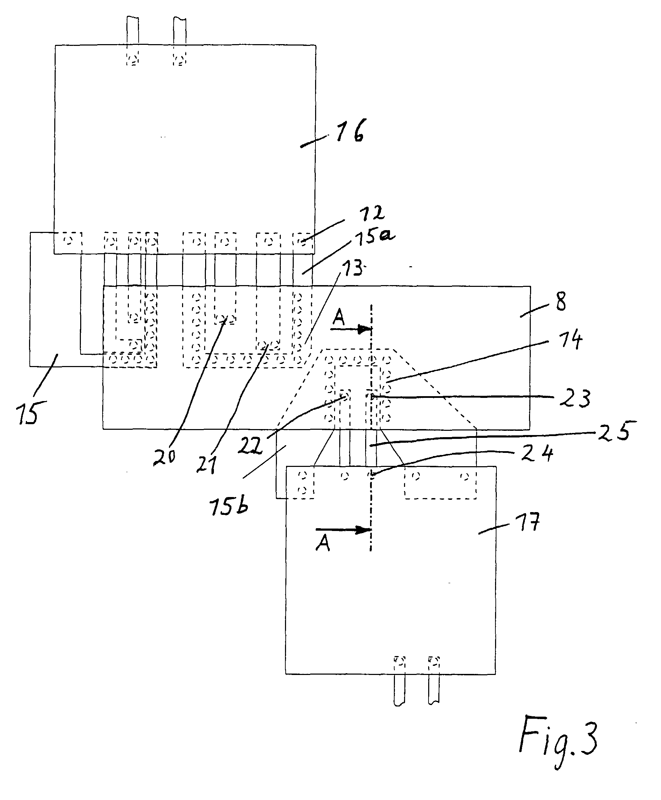

Die restlichen Figuren beziehen sich ebenfalls beispielhaft auf eine Anwendung in der optischen Nachrichtentechnik, nämlich auf den erfindungsgemäßen Aufbau eines Transceivermoduls mit Hilfe eines Transceiver-Photonic-Integrated-Circuits, kurz Transceiver-PIC oder TRx-PIC genannt. (Die Anwendung der beschriebenen Erfindung ist aber nicht allein auf die optische Nachrichtentechnik beschränkt, sondern kann auch für den Aufbau von ICs in der Mikrowellentechnik Anwendung finden). Der Aufbau eines Transceivermoduls erfordert eine geeignete und aufeinander abgestimmte Auslegung des Transceiver-PIC Layouts (Figur 2) und des Substratlayouts (Figur 3), auf dem der Transceiver-PIC montiert werden soll, beispielsweise ein Si-Motherboard.

Figur 2 zeigt eine Seite eines TRx-PIC 8 mit seinem Sendezweig 10 und seinem Empfangszweig 11 sowie Kontaktflächen 12 für Flip-Chip-Bumps. Von diesen sind mehrere auf dem Sendezweig in einer U-förmigen Linie 13 aufgereiht, und zwar in einem gegenseitigen Abstand von nicht mehr als einem Viertel der kürzesten elektrischen Wellenlänge, die der höchsten Frequenz entspricht, welche vom Senderanschluß (2) auf den Empfängeranschluß (1) übersprechen kann. Eine weitere (auf dem Kopf stehende) U-förmige Linie 14 ist auf dem Empfangszweig zu sehen.

In Figur 3 befinden sich über der Zeichenebene (die dem nicht dargestellten Substrat 7 (Board) der Figur 1 entspricht) Leiterbahnen 15, 15a, 15b, 25 des Substrats, die teilweise verdeckt sind durch einen Lasertreiber-IC 16, einen Vorverstärker-IC 17 und den gegenüber Figur 2 umgeklappten TRx-PIC 8. Die U-förmige Linie 13 von Flip-Chip-Bumps beispielsweise umgreift zangenförmig Transceiveranschlüsse 20, 21 des Sendezweiges des TRx-PIC 8. Die Transceiveranschlüsse 22 und 23 des Empfangszweiges werden von der Linie 14 umgriffen.

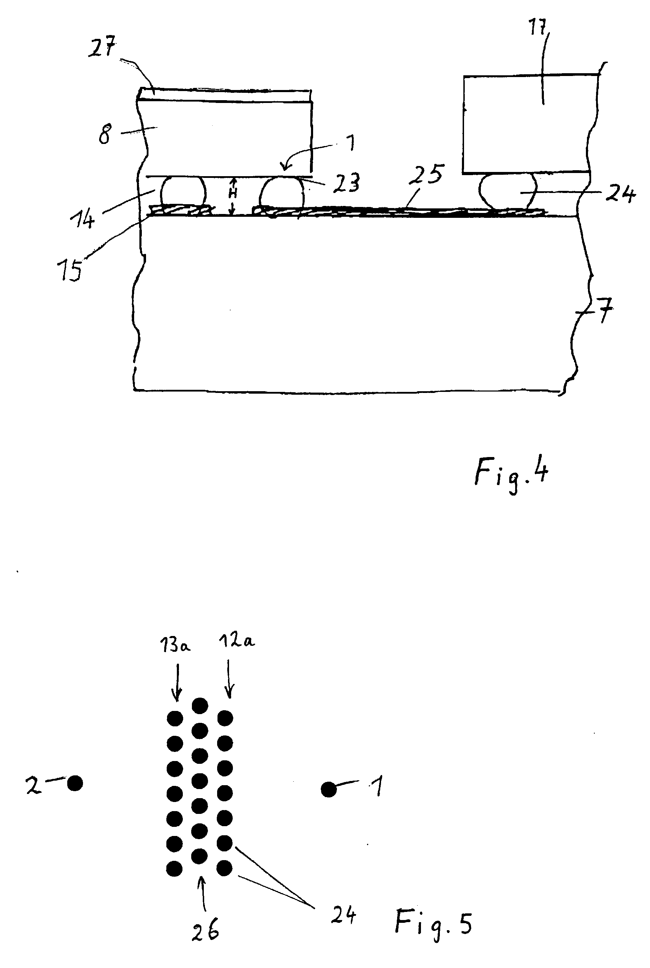

Durch das Schnittbild A - A nach Figur 4 wird der Aufbau der Anordnung nach Figur 3 verdeutlicht, wobei mit 24 ein Flip-Chip-Bump an dem Vorverstärker-IC 17 und mit 25 eine Leiterbahn auf dem Substrat 7 bezeichnet ist.

In Figur 5 ist eine Anordnung mit verbesserter Wirkung gezeigt, bei der mehrere Linien 13a, 26, 12a von Flip-Chip-Bumps zwischen einem Transceiveranschluß 2 des Sendezweiges und einem Transceiveranschluß 1 des Empfangszweiges angeordnet sind, wobei die Flip-Chip-Bumps 24 benachbarter Linien auf Lücke gegeneinander versetzt sind.

Durch die linienförmige oder auch matrixartige, beispielsweise zur Verbesserung der Wirkung auch gegeneinander versetzte (Figur 5), Anordnung von Flip-Chip-Bumps 24 mit möglichst geringem (im Grenzfall durch den Stand der Flip-Chip-Technologie gegebenen Abstand) werden "Vorhänge" aus Flip-Chip-Bumps zwischen dem Sende- und dem Empfangszweig auf dem Chip aufgebaut, die eine abschirmende Wirkung aufweisen (Figur 3 und Figur 4).

Der durch die Höhe H der Flip-Chip-Bumps 24 (Figur 4) einstellbare geringe Abstand zwischen Transceiver-Chip 8 und Substrat 7 (beispielsweise Si-Motherboard) verringert das elektrische Übersprechen zusätzlich durch die Verkleinerung der für eine parasitäre Kopplung maßgeblichen Flächen. Dies wird besonders offensichtlich im Vergleich zu den bei konventionellen Bonds (Figur 1) gegebenen unvermeidlich großen, von den Bonddrähten 3, 4 eingeschlossenen Schleifen ("loops"), die zu einer erhöhten induktiven Kopplung führen. Diese Bonddrähte sind bei der Anordnung nach der Erfindung dadurch vermieden, daß diejenige Seite des Flip-Chips 8, welche die Transceiveranschlüsse 1, 2 (Figur 1) beziehungsweise Kontaktflächen 12 (Figur 2) trägt, nun dem Substrat 7 und dessen Leiterbahnen (beispielsweise 25, Figur 4) zugewandt ist.

Die abschirmenden Flip-Chip-Bumps 24 und die dazugehörigen Metallflächen ( = Leiterbahnen) auf den Chips 8, 16, 17 und auf dem Substrat 7 können mit entsprechenden für den Sende- und dem Empfangszweig getrennten Masseflächen verbunden sein (Figur 3 und Figur 4) und erlauben somit die Einbindung des Transceiver-Chips 8 in ein durch EMV-Forderungen gegebenes Versorgungsspannungs- und Abschirmkonzept.

Die Abschirmwirkung kann zusätzlich durch eine ganzflächige oder (bevorzugt) nach Sende- und Empfangsteil geteilte Rückseitenmetallisierung 27 am TRX-PIC 8 (Figur 4) weiter verbessert werden. Diese Rückseitenmetallisierungen können beispielsweise entweder (elektrisch am vorteilhaftesten, aber aufwendiger in der Herstellung) durch auf dem Chip integrierte Durchkontaktierungen ( 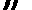 Vias") angeschlossen sein oder durch Bonden oder leitfähiges Kleben über die Chipkanten.

Eine weitere Verbesserung der Übersprechdämpfung läßt sich durch den Einbau eines Vorverstärkerchips (Empfängerseite) und eines Treiberchips (Sendeseite) ins Modulgehäuse erzielen. Diese Chips werden vorteilhafterweise ebenfalls in Flip-Chip-Technik aufgebaut und somit in das beschriebene Abschirmkonzept optimal eingebunden.

### Abwandlungsmöglichkeiten:

Die Anwendung der vorliegenden Erfindung ist nicht nur auf die optische Nachrichtentechnik beschränkt, worauf sich die Figuren beziehen, sondern kann auch bei elektrischen Transceivermodulen in der Mikrowellentechnik (beispielsweise in Mobiltelefonen etc.) vorteilhaft angewendet werden, die mit extrem kleinem Flächenbedarf aufgebaut und bei geringen Kosten ausreichend geschirmt werden müssen!

Die Abschirmwirkung kann durch Unterfüllen mit einem elektrisch und/oder magnetiisch leitfähigen Unterfüller erhöht werden. Der Unterfüllbereich muß dabei durch Kapillarwirkung und geeignete Anordnung der Flip-Chip-Bumps auf den Abschirmbereich (beispielsweise auf die Linien 13a, 26, 12a in Figur 5) beschränkt werden.

## Patentansprüche

1. Transceivermodul mit einem Sender und einem Empfänger auf einem Chip, der in Flip-Chip-Technik auf einem Substrat (7) aufgebaut ist,
dadurch gekennzeichnet, daß auf diesem Flip-Chip(8) zwischen einem elektrischen Senderanschluß (2) einerseits und einem elektrischen Empfängeranschluß (1) andererseits eine elektromagnetisch abschirmende Reihe von Flip-Chip-Bumps (24) in einer Linie (13, 14) angeordnet ist, die mit einer Leiterbahn (15, 15a, 15b) auf dem Substrat (7) elektrisch verbunden sind, wobei die Abstände dieser Flip-Chip-Bumps (24) voneinander und/oder der Abstand zwischen Flip-Chip (8) und Substrat (7) nicht größer sind als ein Viertel derjenigen kürzesten elektrischen Wellenlänge, die der höchsten elektrischen Frequenz entspricht, welche vom Senderanschluß (2, 20, 21) auf den Empfängeranschluß (1, 22, 23) übersprechen kann.

2. Transceivermodul nach Anspruch 1, dadurch gekennzeichnet, daß die Linie (13, 14) einen oder mehrere Transceiveranschlüsse (20, 21; 22, 23) entweder des Sendezweiges (10) oder des Empfangszweiges (11) von wenigstens zwei Seiten her umgreift.

3. Transceivermodul nach Anspruch 1 oder 2, dadurch gekennzeichnet, daß wenigstens zwei Linien (12a, 26) nebeneinander in einem Abstand voneinander angeordnet sind, der nicht größer ist als ein Viertel der kürzesten elektrischen Wellenlänge, die der höchsten Frequenz entspricht, welche vom Senderanschluß (2) auf den Empfängeranschluß (1) übersprechen kann.

4. Transceivermodul nach Anspruch 3, dadurch gekennzeichnet, daß die Flip-Chip-Bumps (24) einer Linie (12a) in deren Längsrichtung gegenüber den Flip-Chip-Bumps der benachbarten Linie (26) auf Lücke versetzt sind.

5. Transceivermodul nach einem der vorangehenden Ansprüche, dadurch gekennzeichnet, daß auf dem Substrat (7) eine Leiterbahn (15, 15a, 15b) vorgesehen ist, die mit den Flip-Chip-Bumps (24) einer Linie (13, 14) elektrisch verbunden ist.

6. Transceivermodul nach Anspruch 5, dadurch gekennzeichnet, daß zwei elektrisch voneinander getrennte Leiterbahnen (15a, 15b) vorgesehen sind einerseits für diejenige Linie (13), welche wenigstens einem Flip-Chip-Bump (24) für einen Senderanschluß (20, 21) abschirmend zugeordnet ist, und andererseits für diejenige Linie (14), welche wenigstens einem Flip-Chip-Bump (24) für einen Empfängeranschluß (22, 23) zugeordnet ist.

7. Transceivermodul nach einem der vorangehenden Ansprüche, dadurch gekennzeichnet, daß auf der den Flip-Chip-Bumps (24) abgewandten Seite des Flip-Chips (8) wenigstens eine abschirmende Metallschicht (27) vorgesehen ist.

8. Transceivermodul nach einem der vorangehenden Ansprüche, dadurch gekennzeichnet, daß der Zwischenraum zwischen Flip-Chip (8) und Substrat (7) im Bereich wenigstens einer Linie (13a, 26, 12a) von Flip-Chip-Bumps mit einem elektrisch und/oder magnetisch leitfähigen Unterfüller derart gefüllt ist, daß sich die Abschirmwirkung erhöht.
